(19) Europäisches Patentamt European Patent Office Office européen des brevets

(11) **EP 3 815 869 B1**

(12) **EUROPEAN PATENT SPECIFICATION**

(45) Date of publication and mention of the grant of the patent:
**13.09.2023 Bulletin 2023/37**

(21) Application number: **19834878.1**

(22) Date of filing: **08.07.2019**

(51) International Patent Classification (IPC):
**B29D 7/01** (2006.01)   **B29C 48/08** (2019.01)
**H05K 1/03** (2006.01)   **H05K 3/00** (2006.01)

(52) Cooperative Patent Classification (CPC):
**B29C 48/0011; B29C 48/08; B29D 7/01;**
**H05K 1/0393; H05K 3/0014;** B29K 2079/08;
B29K 2105/0079; B32B 38/10; H05K 3/022;
H05K 2201/0129; H05K 2201/0141;
H05K 2203/1545

(86) International application number:
**PCT/JP2019/026928**

(87) International publication number:
**WO 2020/013106 (16.01.2020 Gazette 2020/03)**

(54) **METHOD FOR PRODUCING THERMOPLASTIC LIQUID-CRYSTAL POLYMER FILM**

VERFAHREN ZUR HERSTELLUNG EINES THERMOPLASTISCHEN FLÜSSIGKRISTALLPOLYMERFILMS

MÉTHODE DE PRODUCTION DE FILM POLYMÈRE À CRISTAUX LIQUIDES THERMOPLASTIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **10.07.2018 JP 2018130892**

(43) Date of publication of application:
**05.05.2021 Bulletin 2021/18**

(73) Proprietor: **Denka Company Limited Tokyo 103-8338 (JP)**

(72) Inventors:
• **UCHIYAMA, Shun Isesaki-shi, Gunma 372-0855 (JP)**
• **INODA, Ikuka Isesaki-shi, Gunma 372-0855 (JP)**

(74) Representative: **Murgitroyd & Company Murgitroyd House 165-169 Scotland Street Glasgow G5 8PL (GB)**

(56) References cited:
**JP-A- H0 852 754    JP-A- H0 852 754**
**JP-A- H0 890 570    JP-A- H0 890 570**
**JP-A- H10 307 208   JP-A- H10 307 208**
**JP-A- 2014 111 699  US-A- 5 529 740**

EP 3 815 869 B1

**Description**

**TECHNICAL FIELD**

The present invention relates to a method of producing a thermoplastic liquid-crystal polymer film.

**BACKGROUND ART**

A thermoplastic liquid-crystal polymer film is excellent in heat resistance, mechanical strength, electric properties, and so forth and has therefore been widely used as base films for circuit boards and the like in the electric and electronic field as well as in the field of in-vehicle components.

A thermoplastic liquid-crystal polymer film takes on a structure in which straight-chain rigid molecular chains are orderly arranged, and is therefore likely to cause anisotropy. As a consequence, a film obtained by extruding a thermoplastic liquid-crystal polymer generally causes a high degree of molecular orientation in an extruding direction within a plane, and is therefore formed into a film that has high strength in the extruding direction but tears easily in a width direction.

Several technologies for improving the anisotropy of such a thermoplastic liquid-crystal polymer film are known. Patent Literature 1 discloses a processing method designed to heat a thermoplastic liquid-crystal polymer film in a state of contact with a support to a predetermined temperature and then to separate the film from the support after cooling and solidifying the film. Meanwhile, Patent Literature 2 discloses a thermal treatment method for a thermoplastic liquid-crystal polymer film that uses a metal foil having a prescribed degree of maximum roughness and being coated with a silicon-based polymer as a support for a thermal treatment. In this method, a film in a state of being brought into contact with this support is subjected to a thermal treatment, then cooled for solidification, and separated thereafter.

**CITATION LIST**

**Patent Literature**

Patent Literature 1: Japanese Patent Publication No. 3882213
Patent Literature 2: Japanese Patent Application Publication No. 2000-264987

US 5529740 A1 discloses a process for treating a liquid crystal polymer film which includes the steps of: heating a film obtained by extrusion molding of a liquid crystal polymer, while contacting at least one surface of the film with a supporting body, to melt the polymer; cooling the melted polymer to form a solidified polymer layer; and separating the solidified polymer layer from the supporting body. The process readily provides liquid crystal polymer films having excellent resistance to intra-layer delamination and high tensile strength and elongation, as well as excellent resistance to abrasion, dimensional stability when heated, and resistance to folding.

**SUMMARY OF INVENTION**

**Technical Problem**

However, in the processing method disclosed in Patent Literature 1, temperature control at the time of the processing is not always appropriate. Accordingly, this method has room for further improvement in light of improvement in anisotropy. Meanwhile, the thermal treatment method disclosed in Patent Literature 2 can improve the anisotropy of a mechanical property but is designed to carry out the thermal treatment by using a hot-air drying machine. Hence, this has been a method difficult for an industrial use.

An attempt to improve the anisotropy of the thermoplastic liquid-crystal polymer film becomes more difficult as its film thickness grows larger due to the following reason. Specifically, while a thick film is usually formed by extrusion molding, the extrusion molding is apt to apply shearing force during passage of a T-die and thus to develop the anisotropy. The anisotropy of the thermoplastic liquid-crystal polymer film can be evaluated based on a degree of plane orientation in a direction of a film plane and by thermal expansion coefficients in a planar direction and a thickness direction. In the meantime, the thermoplastic liquid-crystal polymer film may also develop a defect in appearance such as undulation and warp stipes attributed to a variation in thermal history and the like in the process of conducting heating and cooling treatments. Such a defect in appearance of the film can be evaluated based on a brightness difference between locations within the film plane.

The present invention has been made in response to the above issue. That is to say, an object of the present invention is to provide a method for producing a thermoplastic liquid-crystal polymer film having a low degree of anisotropy in the degree of plane orientation and thermal expansion coefficient and having excellent appearance even when the thermoplastic liquid-crystal polymer film is thick

**Solution to Problem**

The inventors of the present invention have found out that the above issue can be solved by heating and melting a thermoplastic liquid-crystal polymer film in a state where opposite surfaces of the film are brought into contact with two support sheets so as to rearrange molecular arrangement in the film, and then fixing the molecular arrangement by quenching the film at a predetermined cooling rate. The inventors have successfully arrived at the present invention based on the above-described findings. Specifically, the present invention has the following configurations.

(1) A method of producing a thermoplastic liquid-crystal polymer film includes forming a thermoplastic liquid-crystal polymer film having opposite surfaces by molding a thermoplastic liquid-crystal polymer, melting the thermoplastic liquid-crystal polymer film by heating the thermoplastic liquid-crystal polymer film with the opposite surfaces being in contact with two support sheets at a temperature of from a melting point of the thermoplastic liquid-crystal polymer to a temperature higher than the melting point by 70 °C, cooling the melted thermoplastic liquid-crystal polymer film to a temperature equal to or less than a crystallization temperature of the thermoplastic liquid-crystal polymer at a cooling rate of from 3°C per second to 7°C per second, and separating the cooled thermoplastic liquid-crystal polymer film from the support sheets.
(2) In some embodiments, the melting by the heating and the cooling are carried out under a predetermined pressure.
(3) In some embodiments, the support sheets are a polyimide film subjected to mold releasing treatment.
(4) In some embodiments, the melting by the heating and the cooling are carried out with the thermoplastic liquid-crystal polymer film and the two support sheets being intervening between two metallic endless belts.

**Advantageous Effects of Invention**

According to the method of producing a thermoplastic liquid-crystal polymer film of the present invention, it is possible to obtain a thermoplastic liquid-crystal polymer film having a low degree of anisotropy in the degree of plane orientation and thermal expansion coefficient, and having excellent appearance. In particular, it is possible to obtain a thermoplastic liquid-crystal polymer film having the low degree of anisotropy and excellent appearance even in a case of a thickness of 100 um or higher which cannot be handled by a conventional inflation method.

**BRIEF DESCRIPTION OF DRAWINGS**

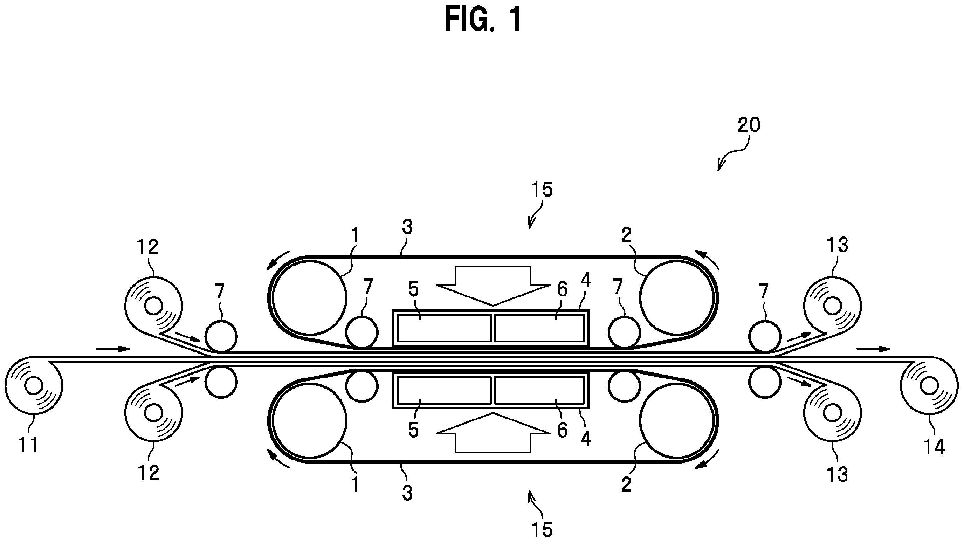

FIG. 1 is a schematic cross-sectional view of production equipment for a thermoplastic liquid-crystal polymer film used in a heating and melting step, a cooling step, and a separating step.

DESCRIPTION OF EMBODIMENT

An embodiment of the present invention will be described below in detail. It is to be noted, however, that the technical scope of the present invention is not limited to the embodiment described below as a specific example.

(Thermoplastic liquid-crystal polymer)

A liquid-crystal polymer means a polymer that takes on a liquid crystal state or an optical birefringence property when melted, examples of which generally include a lyotropic liquid crystal polymer that exhibits a liquid crystal property in a state of a solution, and a thermotropic liquid crystal polymer that exhibits a liquid crystal property when melted. Such liquid crystal polymers are categorized into types I, II, and III based on heat distortion temperatures thereof. Any types of liquid crystal polymers are applicable.

Examples of a thermoplastic liquid-crystal polymer include thermoplastic aromatic liquid-crystal polyester, thermoplastic aromatic liquid-crystal polyesteramide formed by introducing an amide bond to this polymer, and the like. Meanwhile, the thermoplastic liquid-crystal polymer may be any of polymers obtained by further introducing an imide bond, a carbonate bond, a carbodiimide bond, an isocyanate-derived bond such as an isocyanurate bond, and the like to aromatic polyester or aromatic polyesteramide.

Each of molecules of the thermoplastic liquid-crystal polymer has a rigid rod-like structure and the molecules are solidified in a state of being aligned in a direction of a molding flow during the molding. Accordingly, a molded product is excellent in dimensional stability but is predisposed to develop anisotropy. Meanwhile, the thermoplastic liquid-crystal polymer is also excellent in heat resistance, stiffness, chemical resistance, and so forth, and is therefore used as base films for circuit boards and the like in the electric and electronic field as well as in the field of in-vehicle components.

The thermoplastic liquid-crystal polymer causes little entanglement of high molecules and has high fluidity in a melted state. For this reason, the anisotropy of the thermoplastic liquid-crystal polymer film molded once is relaxed by heating the thermoplastic liquid-crystal polymer again to its melting point or above so as to break the orientation of the molecules formed at the time of the molding.

[Production equipment for thermoplastic liquid-crystal polymer film]

FIG. 1 is a schematic cross-sectional view of production equipment 20 for a thermoplastic liquid-crystal polymer film used in a heating and melting step, a cooling step, and a separating step of this embodiment. The thermoplastic liquid-crystal polymer film production equipment 20 is hydraulic double belt press production equipment, which is capable of continuously processing a thermoplastic liquid-crystal polymer film and is excellent in productivity.

A roll 11 of a lengthy thermoplastic liquid-crystal polymer film formed in a film forming step and rolls 12 of two lengthy support sheets to be laminated on opposite surfaces of the thermoplastic liquid-crystal polymer film are installed in the production equipment 20. The thermoplastic liquid-crystal polymer film drawn out of the roll 11 is sandwiched between the two support sheets drawn out of the rolls 12 and supplied to a space between two conveyor apparatuses 15.

The production equipment 20 includes two conveyor apparatuses 15 arranged vertically. Each conveyor apparatus 15 drives an endless belt 3 by using two endless belt rollers 1 and 2. Inside the conveyor apparatus 15, there is provided a pressure block 4 that includes a built-in heater block 5 and a built-in cooling block 6. The two conveyor apparatuses 15 can heat and then cool the thermoplastic liquid-crystal polymer film and the two support sheets put through the two conveyor apparatuses 15 while holding the thermoplastic liquid-crystal polymer film and the support sheets between the two endless belts 3 and continuously applying a prescribed pressure thereto. The material of the endless belts 3 is not limited to a particular material and a metal, a resin, a rubber, and the like are applicable. However, a metal is preferred in light of its heat resistance and low thermal expansion.

The pressure block 4 has a capability of applying the prescribed pressure to the thermoplastic liquid-crystal polymer film and the support sheets. The inside of the pressure block 4 is filled with an oil so that the pressure block 4 can apply a hydraulic pressure. The capability of applying the hydraulic pressure makes it possible to apply uniform pressure to a film plane and therefore reduces the chance of occurrence of a defect in appearance. The heater block 5 has a function with which it is possible to heat the thermoplastic liquid-crystal polymer film and the support sheets to a predetermined temperature equal to or above the melting point of the thermoplastic liquid-crystal polymer. The cooling block 6 has a function with which it is possible to cool the thermoplastic liquid-crystal polymer film and the support sheets to a temperature equal to or below a crystallization temperature of the thermoplastic liquid-crystal polymer at a predetermined cooling rate.

The production equipment 20 includes multiple guide rollers 7 for conveying the thermoplastic liquid-crystal polymer film and the support sheets. Moreover, the production equipment 20 can separate the thermoplastic liquid-crystal polymer film from the support sheets after being processed with the two conveyor apparatuses 15 and reel them in as a roll 14 of the thermoplastic liquid-crystal polymer film and rolls 13 of the support sheets, respectively.

The support sheets are used in a stacked state in contact with opposite surfaces of the thermoplastic liquid-crystal polymer film. Each support sheet has a function to hold and protect the thermoplastic liquid-crystal polymer film when pressurizing, heating, and cooling the thermoplastic liquid-crystal polymer film. In order to avoid displacement from the thermoplastic liquid-crystal polymer film that adheres to the support sheet during the heating, the support sheet may have a thermal behavior such as a heating dimensional change rate, which is close to that of the thermoplastic liquid-crystal polymer film.

A resin sheet or a metal sheet having excellent heat resistance is used as the support sheet. Examples of the resin sheet having excellent heat resistance include a polyimide film, a PTFE film, and the like. The polyimide film is preferable because of ease of separation from the metallic endless belt, excellent heat resistance, and a small heating dimensional change. Kapton (registered trademark) manufactured by Du Pont-Toray Co., Ltd. and Apical (registered trademark) manufactured by Kaneka Corporation have been known as commercially available resin sheet products that are excellent in heat resistance. Examples of the metal sheet include an aluminum foil, a copper foil, a stainless steel foil, and the like.

In some embodiments, a thickness of each support sheet is in a range from 25 to 200 um or in a range from 50 to 125 um. If the thickness of the support sheet exceeds 200 um, the thermoplastic liquid-crystal polymer film is prone to be heated and melted insufficiently due to a reason related to heat conduction. Meanwhile, in some embodiments, the support sheet is a sheet with a surface subjected to mold releasing treatment. As for a method of the mold releasing treatment, a publicly known method can be used as appropriate. Moreover, the support sheets can be repeatedly used after the separation from the thermoplastic liquid-crystal polymer film.

[Method of producing thermoplastic liquid-crystal polymer film]

A method of producing a thermoplastic liquid-crystal polymer film of this embodiment includes (1) a film production step of forming a thermoplastic liquid-crystal polymer film, (2) a heating and melting step of melting the thermoplastic liquid-crystal polymer film, (3) a cooling step of cooling the thermoplastic liquid-crystal polymer film, and (4) a separation step of separating the thermoplastic liquid-crystal polymer film from support sheets. Among these steps, the heating and melting step, the cooling step, and the separation step may be carried out by using the hydraulic double belt press production equipment 20 in FIG. 1. While the respective steps of the method of producing a thermoplastic liquid-crystal polymer film can be carried out as a batch method, these steps may be carried out as a continuous method from the viewpoint of productivity. Now, the respective steps will be described below.

(Film production step)

In the film production step, the thermoplastic liquid-crystal polymer film is formed by molding the thermoplastic liquid-crystal polymer. A film production method of forming the thermoplastic liquid-crystal polymer film is not limited to a particular method and a publicly known method can be used. Specifically, examples of the production method for the thermoplastic liquid-crystal polymer film include extrusion molding methods such as an inflation method and a T-die method, a casting method, a colander method, and the like. Among them, the T-die method is most versatile. In the case of molding in accordance with the T-die method, shearing force is applied during passage of a T-die whereby the molecules are apt to be oriented and to develop the anisotropy.

Given the circumstances, the inventors have investigated a method for reducing the anisotropy of the thermoplastic liquid-crystal polymer film. As described earlier, the anisotropy of the thermoplastic liquid-crystal polymer once molded is relaxed by heating the thermoplastic liquid-crystal polymer again to its melting point or above so as to break the orientation of the molecules formed at the time of the molding. The thermoplastic liquid-crystal polymer film with the reduced anisotropy can be obtained by fixing this state of the relaxed anisotropy. The inventors have succeeded in obtaining the thermoplastic liquid-crystal polymer film with the improved anisotropy by heating and melting the thermoplastic liquid-crystal polymer film again at the temperature of the melting point or above under application of a prescribed pressure, and then quenching the film at a predetermined cooling rate so as to solidify the film in the state of the relaxed anisotropy.

(Heating and melting step)

The heating and melting step is a step of heating and melting the thermoplastic liquid-crystal polymer film, in a state where opposite surfaces thereof are brought into in contact with the two support sheets, at a temperature equal to or greater than the melting point of the thermoplastic liquid-crystal polymer and equal to or less than a temperature 70°C above the melting point. The temperature of the thermoplastic liquid-crystal polymer film itself and a heating rate were measured by inserting a thermocouple between the two support sheets and then putting them through the two endless belts 3 together with the film. By heating and melting the thermoplastic liquid-crystal polymer film to the melting point or above, it is possible to disentangle the high molecules, thereby breaking the orientation of the molecules and relaxing the anisotropy. For this reason, the heating temperature of the thermoplastic liquid-crystal polymer film needs to be set equal to or above the melting point of the thermoplastic liquid-crystal polymer. On the other hand, it is not desirable to set the heating temperature of the thermoplastic liquid-crystal polymer film in excess of the temperature 70°C above the melting point because the polymer will be deteriorated by this heat. In some embodiments, the heating temperature of the thermoplastic liquid-crystal polymer film is set at a temperature equal to or greater than the melting point of the thermoplastic liquid-crystal polymer and equal to or less than a temperature 50°C above the melting point.

In the heating and melting step, a time period for heating at the temperature equal to or greater than the melting point of the thermoplastic liquid-crystal polymer and equal to or less than the temperature 70°C above the melting point may be set in a range from 1 to 900 seconds or in a range from 5 to 600 seconds. Meanwhile, in some embodiments, the heating in the heating and melting step is conducted in such a way as to heat evenly from opposite surfaces of the thermoplastic liquid-crystal polymer.

(Cooling step)

The cooling step is a step of cooling the melted thermoplastic liquid-crystal polymer film at a cooling rate in a range of 3°C to 7°C per second to a temperature equal to or less than the crystallization temperature of the thermoplastic liquid-crystal polymer. The temperature of the thermoplastic liquid-crystal polymer film itself and a cooling rate were measured by inserting the thermocouple between the two support sheets and then putting them through the two endless belts 3 together with the film. By quenching the thermoplastic liquid-crystal polymer film heated to its melting point or above, in the heating and melting step, at the cooling rate in the range of 3°C to 7°C per second, the thermoplastic liquid-crystal polymer film is solidified in the state of the relaxed anisotropy. If the cooling rate of the thermoplastic liquid-crystal polymer film falls below 3°C per second, the polymer is liable to cause a variation and to develop a defect in appearance. Since sufficient cooling is required for preventing the defect in appearance, either a line speed needs to be slowed down or a line length needs to be extended in order to prevent the defect in appearance in the case where the cooling rate of the thermoplastic liquid-crystal polymer film falls below 3°C per second. The former results in deterioration in productivity while the latter increases costs of the production equipment. Therefore, neither is preferable. On the other hand, the cooling rate of the thermoplastic liquid-crystal polymer film in excess of 7°C per second leads to a state where a molding strain remains due to the quenching, which is liable to increase the anisotropy of the degree of plane orientation or of the linear expansion coefficient. Meanwhile, in some embodiments, the cooling in the cooling step is conducted in such a way as to cool evenly from opposite surfaces of the thermoplastic liquid-crystal polymer in order to reduce the chance of developing defects such as warpage.

In the cooling step, the thermoplastic liquid-crystal polymer film needs to be cooled down below the crystallization temperature of the thermoplastic liquid-crystal polymer. By cooling the thermoplastic liquid-crystal polymer film to the temperature equal to or below the crystallization temperature of the thermoplastic liquid-crystal polymer as the cooling temperature, the state of the relaxed anisotropy in the thermoplastic liquid-crystal polymer film is fixed whereby the form of the thermoplastic liquid-crystal polymer film is stabilized. If the cooling temperature is equal to or above the crystallization temperature, the pressure is released before the thermoplastic liquid-crystal polymer is solidified. Hence, the thermoplastic liquid-crystal polymer is liable to cause free deformation that may lead to the defect in appearance. On the other hand, if the thermoplastic liquid-crystal polymer is quenched down below a temperature that is 70°C below the crystallization temperature, there is a risk of an increase in molding strain that may lead to an increase in heating dimensional change.

The heating and melting step and the cooling step may be carried out in a state of intervening the thermoplastic liquid-crystal polymer film and the support sheets between the two endless belts 3. Moreover, in some embodiments, the heating and melting step and the cooling step are carried out under application of a pressure. When the heating and melting step and the cooling step are carried out under application of the pressure, it is possible to suppress deformation of the thermoplastic liquid-crystal polymer film during the process, so that the occurrence of the defect in appearance such as undulation and warp stipes can be suppressed by evening out a variation in thermal history. A pressing force in the heating and melting step and the cooling step may be set in a range from 1 to 7 MPa or in a range from 1 to 3 MPa.

(Separation step)

The separation step is a step of separating the cooled thermoplastic liquid-crystal polymer film from the support sheets. The form of the thermoplastic liquid-crystal polymer film is stable since the film is cooled down to the crystallization temperature of the thermoplastic liquid-crystal polymer or below this temperature, so that the thermoplastic liquid-crystal polymer film can be separated from the support sheets.

The thermoplastic liquid-crystal polymer film which is excellent in anisotropy of the degree of plane orientation and the linear expansion coefficient and is also excellent in appearance can be continuously obtained by conducting the respective steps described above under appropriate conditions by using the hydraulic double belt press production equipment 20 in FIG. 1. In this instance, the line speed of the production equipment 20 can be changed as appropriate so as to satisfy the heating and cooling temperature conditions and the cooling rate of the present invention. Nonetheless, in some embodiments, from the economical perspective, the line speed is set in a range from 0.1 to 10 m/min or in a range from 0.7 to 10 m/min.

[Thermoplastic liquid-crystal polymer film]

The thermoplastic liquid-crystal polymer film which is excellent in anisotropy of the degree of plane orientation and the linear expansion coefficient with fewer defects in appearance can be obtained by the production in accordance with the above-described production method of this embodiment. Characteristics of the thermoplastic liquid-crystal polymer film obtained in accordance with the above-described production method of this embodiment will be discussed below.

The thermoplastic liquid-crystal polymer film may have a thickness in a range from 100 to 500 um or in a range from 200 to 400 μm.

The thermoplastic liquid-crystal polymer film has the plane orientation degree below 65%, which represents a scale of in-plane anisotropy. The plane orientation degree is calculated by the following formula from a half width $\phi 1$ (degrees) of a diffraction intensity curve corresponding to a [006] plane obtained by irradiation of a film plane with X-rays in a direction perpendicular to the film plane by using a wide-angle X-ray diffraction apparatus:

$$\text{degree of plane orientation (\%)} = [(180-\phi 1)/180] \times 100.$$

The degree of plane orientation (%) may be below 60%.

As the scale of anisotropy in the in-plane and thickness directions, the thermoplastic liquid-crystal polymer film has the following mean coefficient of thermal expansion at a temperature in a range from 23°C to 200°C, namely, a value in a range from 20 to 60 ppm/K in an MD direction, a value in a range from 40 to 90 ppm/K in a TD direction, and a value in a range from 0 to 300 ppm/K in the thickness direction. Here, the mean coefficient of thermal expansion is obtained by using TMA in accordance with JIS K7197. The mean coefficient of thermal expansion at a temperature in the range from 23°C to 200°C may be a value in a range from 30 to 50 ppm/K in the MD direction, a value in a range from 50 to 80 ppm/K in the TD direction, and a value in a range from 0 to 140 ppm/K in the thickness direction. Here, the MD direction is a direction of a molding flow (a machine direction) within the film plane while the TD direction is a direction perpendicular to the MD direction within the film plane.

The thermoplastic liquid-crystal polymer film has a brightness difference $\Delta L^*$ within the film plane equal to or below 0.5, which is measured in accordance with JIS K7105. Here, the brightness difference $\Delta L^*$ within the film plane measured in accordance with JIS K7105 represents a difference between a maximum value and a minimum value of brightness $L^*$ in a case where the brightness $L^*$ is measured at ten locations picked up at random within the film plane. The brightness difference $\Delta L^*$ within the film plane is used as a scale of defects in appearance such as undulation and warp stipes on the film. The brightness difference $\Delta L^*$ within the film plane may be equal to or below 0.3.

Examples of applications of the thermoplastic liquid-crystal polymer film in the electric and electronic field as well as in the field of in-vehicle components include a high heat resistance flexible printed board, a solar panel board, a high frequency wiring board, and so forth. In particular, the thermoplastic liquid-crystal polymer film is suitable for a flexible copper-clad laminate that uses the thermoplastic liquid-crystal polymer film as its baseplate.

**Examples**

The embodiment of the present invention will be more specifically discussed below by using examples and comparative examples. It is to be noted, however, that the present invention is not limited only to these examples.

The following are the materials used in the examples and the comparative examples.

(1) Thermoplastic liquid-crystal polymer film
thermoplastic liquid-crystal polymer film: product number A-5000, manufactured by Ueno Fine Chemical Industry, Ltd., melting point 280°C, crystallization temperature 230°C, thicknesses 100, 250, 500 um, and
(2) Support sheets
polyimide film subjected to mold releasing treatment: product number 200 EN, manufactured by Du Pont-Toray Co., Ltd., thickness 50 um.

(Examples 1 to 9 and Comparative Examples 1 to 6)

The heating and melting step, the cooling step, and the separation step were carried out on the above-mentioned commercially available thermoplastic liquid-crystal polymer films by using the production equipment 20 shown in FIG. 1 under various conditions described in Table 1 while bringing opposite surfaces of each film into contact with the two support sheets.

Various performances of the respective thermoplastic liquid-crystal polymer films thus obtained were evaluated in accordance with methods described below. Results of evaluation are shown in Table 1.

(Brightness difference $\Delta L^*$)

In accordance with JIS K7105, the brightness $L^*$ was measured at ten locations picked up at random within the film plane, and a difference between the maximum value and the minimum value of brightness $L^*$ was obtained. A value equal to or below 0.5 was judged to be acceptable.

(Plane orientation degree)

The degree of plane orientation was calculated by using the following formula from the half width $\phi 1$ (degrees) of the diffraction intensity curve corresponding to the [006] plane obtained by irradiation of each film plane with X-rays from the direction perpendicular to the film plane by using the wide-angle X-ray diffraction apparatus:

$$\text{degree of plane orientation (\%)} = [(180-\phi 1)/180]\times 100.$$

A value below 65% was judged to be acceptable.

(Linear expansion coefficient)

The mean coefficient of thermal expansion at a temperature in the range from 23°C to 200°C in the MD direction, the TD direction, and the thickness direction were obtained by using TMA in accordance with JIS K7197.

As for judgment criteria, the linear expansion coefficient in the MD direction in the range from 20 to 60 ppm/K was judged to be acceptable. Meanwhile, the linear expansion coefficient in the TD direction in the range from 40 to 90 ppm/K was judged to be acceptable. Moreover, the linear expansion coefficient in the thickness direction in the range from 0 to 300 ppm/K was judged to be acceptable.

(Heating dimensional change rate)

The heating dimensional change rates in the MD direction and the TD direction at 150°C were measured by using a method in accordance with JIS K7133.

As for judgment criteria, a value in a range from -0.10% to 0.30% was judged to be acceptable regarding the MD direction while a value in a range from 0% to 0.50% was judged to be acceptable regarding the TD direction.

[Table 1]

| | | | Example 1 | Example 2 | Example 3 | Example 4 | Example 5 | Example 6 | Example 7 | Example 8 |
|---|---|---|---|---|---|---|---|---|---|---|
| | Thickness of liquid-crystal polymer film | μm | 100 | 100 | 100 | 250 | 250 | 250 | 500 | 500 |
| Manufacturing conditions | Heating temperature | °C | 318 | 325 | 328 | 330 | 327 | 324 | 321 | 323 |
| | Cooling temperature | °C | 120 | 162 | 218 | 130 | 159 | 221 | 129 | 161 |
| | Pressing force | MPa | 1 | 1 | 1 | 1 | 1 | 1 | 1 | 1 |
| | Line speed | m/min | 1 | 1 | 1 | 1 | 1 | 1 | 1 | 1 |
| | Cooling rate | °C/sec | 6.3 | 5.2 | 3.5 | 6.4 | 5.4 | 3.3 | 6.1 | 5.2 |
| | Support sheets | | PI | PI | PI | PI | PI | PI | PI | PI |
| | Thickness of support sheets | μm | 50 | 50 | 50 | 50 | 50 | 50 | 50 | 50 |
| Performances | Brightness difference ΔL* | | 0.30 | 0.35 | 0.42 | 0.33 | 0.32 | 0.41 | 0.36 | 0.36 |
| | Plane orientation degree | % | 61 | 60 | 62 | 61 | 60 | 63 | 64 | 62 |
| | Linear expansion coefficient | MD direction | ppm/K | 40 | 45 | 32 | 45 | 46 | 44 | 49 | 51 |
| | | TD direction | | 65 | 62 | 45 | 62 | 63 | 65 | 66 | 59 |
| | | Thickness Direction | | 85 | 81 | 88 | 78 | 74 | 77 | 69 | 74 |
| | Heating dimensional change rate | MD direction | % | 0.29 | 0.22 | 0.16 | 0.25 | 0.21 | 0.15 | 0.22 | 0.18 |
| | | TD direction | | 0.49 | 0.36 | 0.29 | 0.44 | 0.32 | 0.24 | 0.42 | 0.29 |

| | | | Example 9 | Comparative example 1 | Comparative example 2 | Comparative example 3 |
|---|---|---|---|---|---|---|
| | Thickness of liquid-crystal polymer film | μm | 500 | 100 | 100 | 250 |

EP 3 815 869 B1

(continued)

| | | | Example 9 | Comparative example 1 | Comparative example 2 | Comparative example 3 |
|---|---|---|---|---|---|---|
| Manufacturing conditions | Heating temperature | °C | 324 | 325 | 319 | 322 |
| | Cooling temperature | °C | 219 | 275 | 60 | 260 |
| | Pressing force | MPa | 1 | 1 | 1 | 1 |
| | Line speed | m/min | 1 | 1 | 1 | 1 |
| | Cooling rate | °C/sec | 3.3 | 1.6 | 8.2 | 2.0 |
| | Support sheets | | PI | PI | PI | PI |
| | Thickness of support sheets | μm | 50 | 50 | 50 | 50 |
| Performances | Brightness difference ΔL* | | 0.36 | 6.0 | 0.32 | 3.4 |
| | Plane orientation degree | % | 60 | 63 | 67 | 64 |
| | Linear expansion coefficient | MD direction | ppm/K | 44 | 59 | 10 | 55 |
| | | TD direction | | 56 | 53 | 100 | 44 |
| | | Thickness direction | | 87 | 60 | 84 | 60 |
| | Heating dimensional change rate | MD direction | % | 0.11 | 0.19 | 0.46 | 0.15 |
| | | TD direction | | 0.21 | 0.39 | 0.69 | 0.35 |
| | | | | Comparative example 4 | Comparative example 5 | Comparative example 6 |
| | Thickness of liquid-crystal polymer film | μm | | 250 | 500 | 500 |

(continued)

| | | | Comparative example 4 | Comparative example 5 | Comparative example 6 |
|---|---|---|---|---|---|
| Manufacturing conditions | Heating temperature | °C | 321 | 318 | 323 |
| | Cooling temperature | °C | 55 | 255 | 69 |
| | Pressing force | MPa | 1 | 1 | 1 |
| | Line speed | m/min | 1 | 1 | 1 |
| | Cooling rate | °C/sec | 8.5 | 2.0 | 8.1 |
| | Support sheets | | PI | PI | PI |
| | Thickness of support sheets | um | 50 | 50 | 50 |
| Performances | Brightness difference ΔL* | | 0.34 | 5.4 | 0.46 |
| | Plane orientation degree | % | 69 | 61 | 68 |
| | Linear expansion coefficient | MD direction | ppm/K | 8 | 52 | 14 |
| | | TD direction | | 98 | 49 | 120 |
| | | Thickness direction | | 70 | 81 | 85 |
| | Heating dimensional change rate | MD direction | % | 0.41 | 0.12 | 0.36 |
| | | TD direction | | 0.59 | 0.31 | 0.52 |

The results of evaluation in Table 1 reveal that each of Examples 1 to 9 showed favorable performances in light of the brightness difference, the degree of plane orientation, the linear expansion coefficients, and the heating dimensional change rate. Regarding each of Comparative Example 1, Comparative Example 3, and Comparative Example 5, the brightness difference $\Delta L^*$ was large and the appearance was poor because the cooling temperature was higher than the crystallization temperature of the thermoplastic liquid-crystal polymer and the cooling rate was below 3°C/sec. Regarding each of Comparative Example 2, Comparative Example 4, and Comparative Example 6, the cooling rate exceeded 7°C/sec. For this reason, the degree of plane orientation exceeded 65%, the thermal expansion coefficient in the MD direction was small, and the thermal expansion coefficient in the TD direction was large. Thus, the anisotropy within the film plane and the heating dimensional change rate were poor in each case.

**Reference Signs List**

| | |
|---|---|
| 1, 2 | endless belt roller |
| 3 | endless belt |
| 4 | pressure block |
| 5 | heater block |
| 6 | cooling block |
| 7 | guide roll |
| 11, 12, 13, 14 | roll |
| 15 | conveyor apparatus |
| 20 | production equipment |

**Claims**

1. A method of producing a thermoplastic liquid-crystal polymer film comprising:

    forming a thermoplastic liquid-crystal polymer film having opposite surfaces by molding a thermoplastic liquid-crystal polymer;
    melting the thermoplastic liquid-crystal polymer film by heating the thermoplastic liquid-crystal polymer film with the opposite surfaces being in contact with two support sheets at a temperature of from a melting point of the thermoplastic liquid-crystal polymer to a temperature higher than the melting point by 70 °C;
    cooling the melted thermoplastic liquid-crystal polymer film to a temperature equal to or less than a crystallization temperature of the thermoplastic liquid-crystal polymer at a cooling rate of from 3°C per second to 7°C per second; and
    separating the cooled thermoplastic liquid-crystal polymer film from the support sheets.

2. The method of claim 1, wherein the melting by the heating and the cooling are carried out under a predetermined pressure.

3. The method of claim 1 or 2, wherein the support sheets are a polyimide film subjected to mold releasing treatment.

4. The method of any one of claims 1 to 3, wherein the melting by the heating and the cooling are carried out with the thermoplastic liquid-crystal polymer film and the two support sheets being intervening between two metallic endless belts.

**Patentansprüche**

1. Ein Verfahren zum Herstellen einer thermoplastischen Flüssigkristallpolymerfolie, das Folgendes beinhaltet:

    Bilden einer thermoplastischen Flüssigkristallpolymerfolie, die gegenüberliegende Oberflächen aufweist, durch Formen eines thermoplastischen Flüssigkristallpolymers;
    Schmelzen der thermoplastischen Flüssigkristallpolymerfolie durch Erwärmen der thermoplastischen Flüssigkristallpolymerfolie, wobei die gegenüberliegenden Oberflächen in Kontakt mit zwei Stützflächengebilden mit einer Temperatur von ab einem Schmelzpunkt der thermoplastischen Flüssigkristallpolymerfolie bis zu einer Temperatur um 70 °C höher als der Schmelzpunkt stehen;

Abkühlen der geschmolzenen thermoplastischen Flüssigkristallpolymerfolie auf eine Temperatur gleich oder niedriger als eine Kristallisationstemperatur des thermoplastischen Flüssigkristallpolymers mit einer Kühlgeschwindigkeit von 3 °C pro Sekunde bis 7 °C pro Sekunde; und

Trennen der gekühlten thermoplastischen Flüssigkristallpolymerfolie von den Stützflächengebilden.

2. Verfahren gemäß Anspruch 1, wobei das Schmelzen durch das Erwärmen und das Abkühlen unter einem vorbestimmten Druck ausgeführt werden.

3. Verfahren gemäß Anspruch 1 oder 2, wobei die Stützflächengebilde eine Polyimidfolie sind, die einer Formtrennbehandlung unterzogen wurde.

4. Verfahren gemäß einem der Ansprüche 1 bis 3, wobei das Schmelzen durch das Erwärmen und das Abkühlen mit der thermoplastischen Flüssigkristallpolymerfolie und den zwei Stützflächengebilden zwischenliegend zwischen zwei metallischen Endlosbändern ausgeführt werden.

**Revendications**

1. Un procédé de production d'un film de polymère à cristaux liquides thermoplastique comprenant :

la formation d'un film de polymère à cristaux liquides thermoplastique ayant des surfaces opposées par moulage d'un polymère à cristaux liquides thermoplastique ;

la fonte du film de polymère à cristaux liquides thermoplastique par chauffage du film de polymère à cristaux liquides thermoplastique, les surfaces opposées étant en contact avec deux feuilles de support, à une température allant d'un point de fusion du polymère à cristaux liquides thermoplastique à une température plus élevée de 70 °C que le point de fusion ;

le refroidissement du film de polymère à cristaux liquides thermoplastique fondu jusqu'à une température égale ou inférieure à une température de cristallisation du polymère à cristaux liquides thermoplastique à une vitesse de refroidissement allant de 3 °C par seconde à 7 °C par seconde ; et

la séparation du film de polymère à cristaux liquides thermoplastique refroidi des feuilles de support.

2. Le procédé de la revendication 1, dans lequel la fonte par le chauffage et le refroidissement sont mis en aeuvre sous une pression prédéterminée.

3. Le procédé de la revendication 1 ou de la revendication 2, dans lequel les feuilles de support sont un film de polyimide soumis à un traitement de démoulage.

4. Le procédé de n'importe laquelle des revendications 1 à 3, dans lequel la fonte par le chauffage et le refroidissement sont mis en oeuvre avec le film de polymère à cristaux liquides thermoplastique et les deux feuilles de support interposés entre deux courroies sans fin métalliques.

**FIG. 1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 3882213 B
- JP 2000264987 A

- US 5529740 A1